# EUROPEAN PATENT APPLICATION

(11) **EP 4 521 894 A2**
(43) Date of publication of application: **12.03.2025**
(21) Application number: 24196699.3
(22) Date of filing: 27.08.2024
(51) Int. Cl.: H10K 50/17, H10K 50/19, H10K 59/122

(54) **DISPLAY DEVICE AND MANUFACTURING METHOD THEREOF**

(30) Priority: 07.09.2023 JP 2023145264
(71) Applicant: Japan Display Inc., Tokyo 105-0003 (JP)
(72) Inventor: USHIKUBO, Takahiro, Tokyo, 105-0003 (JP); KIMURA, Hiroyuki, Tokyo, 105-0003 (JP); ISHIDA, Arichika, Tokyo, 105-0003 (JP); FUKUDA, Kaichi, Tokyo, 105-0003 (JP); KAWAMURA, Shinichi, Tokyo, 105-0003 (JP); TAKENAKA, Takanobu, Tokyo, 105-0003 (JP)
(74) Representative: MERH-IP Matias Erny Reichl Hoffmann Patentanwälte PartG mbB

(57) **Abstract**

According to one embodiment, a display device includes a lower electrode (LE), a partition (6) which has a conductive lower portion (61) and an upper portion (62) provided on the lower portion (61) and protruding from a side surface of the lower portion (61), an organic layer (OR) provided on the lower electrode (LE), and an upper electrode (UE) provided on the organic layer (OR). The organic layer (OR) has a hole injection layer (HIL) spaced apart from the partition (6), a first intermediate layer (M1) including a first light emitting layer (EML1), a first charge generation layer (CGL1) spaced apart from the partition (6), and a second intermediate layer (M2) including a second light emitting layer (EML2). The hole injection layer (HIL) and the first charge generation layer (CGL1) are spaced apart from each other and are further spaced apart from the upper electrode (UE).

## Description

### FIELD

Embodiments described herein relate generally to a display device and a manufacturing method thereof.

### BACKGROUND

Recently, display devices to which an organic light emitting diode (OLED) is applied as a display element have been put into practical use. This display element comprises a pixel circuit including a thin-film transistor, a lower electrode connected to the pixel circuit, an organic layer which covers the lower electrode, and an upper electrode which covers the organic layer.

In the process of manufacturing such a display element, a technique which prevents the reduction in reliability has been required.

### BRIEF DESCRIPTION OF THE DRAWINGS

FIG. 1 is a plan view showing a configuration example of a display device DSP.
FIG. 2 is a diagram showing an example of the layout of subpixels SP1, SP2 and SP3.
FIG. 3 is a schematic cross-sectional view of the display device DSP along the A-B line of FIG. 2.
FIG. 4 is a diagram showing configuration examples of display elements DE1 to DE3.
FIG. 5 is a schematic cross-sectional view showing a configuration example of an organic layer OR.
FIG. 6 is a cross-sectional view of the organic layer OR shown in FIG. 5.
FIG. 7 is a schematic cross-sectional view showing another configuration example of an organic layer OR.
FIG. 8 is a cross-sectional view of the organic layer OR shown in FIG. 7.
FIG. 9 is a diagram for explaining the manufacturing method of the display device.
FIG. 10 is a diagram for explaining the manufacturing method of the display device.
FIG. 11 is a diagram for explaining the manufacturing method of a hole injection layer and a charge generation layer.
FIG. 12 is a diagram for explaining the manufacturing method of an intermediate layer.
FIG. 13 is a diagram for explaining the manufacturing method of the display device.
FIG. 14 is a diagram for explaining the manufacturing method of the display device.
FIG. 15 is a diagram for explaining the manufacturing method of the display device.
FIG. 16 is a diagram for explaining the manufacturing method of the display device.

### DETAILED DESCRIPTION

Embodiments described herein aim to provide a display device in which the degradation of display performance can be prevented and a manufacturing method thereof.

In general, according to one embodiment, a display device comprises a substrate, a lower electrode provided above the substrate, an inorganic insulating layer which covers a peripheral portion of the lower electrode, a partition which has a conductive lower portion provided on the inorganic insulating layer and an upper portion provided on the lower portion and protruding from a side surface of the lower portion, an organic layer provided on the lower electrode, and an upper electrode which is provided on the organic layer and is in contact with the lower portion. The organic layer has a hole injection layer which is spaced apart from the partition and is in contact with the lower electrode, a first intermediate layer provided on the hole injection layer and including a first light emitting layer, a first charge generation layer spaced apart from the partition and provided on the first intermediate layer, and a second intermediate layer provided on the first charge generation layer and including a second light emitting layer. The hole injection layer and the first charge generation layer are spaced apart from each other and are further spaced apart from the upper electrode.

According to another embodiment, a display device comprises a substrate, a lower electrode provided above the substrate, an inorganic insulating layer which covers a peripheral portion of the lower electrode, a partition which has a conductive lower portion provided on the inorganic insulating layer and an upper portion provided on the lower portion and protruding from a side surface of the lower portion, an organic layer provided on the lower electrode, and an upper electrode which is provided on the organic layer and is in contact with the lower portion. The organic layer has a hole injection layer which is spaced apart from the partition and is in contact with the lower electrode, a first intermediate layer covering the hole injection layer and including a first light emitting layer, a first charge generation layer spaced apart from the partition and provided on the first intermediate layer, and a second intermediate layer covering the first intermediate layer and the first charge generation layer and including a second light emitting layer.

According to yet another embodiment, a manufacturing method of a display device comprises forming a lower electrode above a substrate, forming an inorganic insulating layer which covers a peripheral portion of the lower electrode, forming a partition which has a lower portion located on the inorganic insulating layer and formed of a conductive material, and an upper portion located on the lower portion and protruding from a side surface of the lower portion, and forming a stacked film including an organic layer and an upper electrode on the lower electrode by performing vapor deposition using the partition as a mask. The organic layer has a hole injection layer, a first intermediate layer including a first light emitting layer, a first charge generation layer, and a second intermediate layer including a second light emitting layer. Each of the hole injection layer and the first charge generation layer is formed of a material emitted from a first evaporation source at a first evaporation angle, using the partition as a mask. Each of the first intermediate layer and the second intermediate layer is formed of a material emitted from a second evaporation source at a second evaporation angle, using the partition as a mask. The second evaporation angle is greater than the first evaporation angle.

The embodiments can provide a display device in which the degradation of display performance can be prevented and a manufacturing method thereof.

Embodiments will be described hereinafter with reference to the accompanying drawings.

The disclosure is merely an example, and proper changes in keeping with the spirit of the invention, which are easily conceivable by a person of ordinary skill in the art, come within the scope of the invention as a matter of course. In addition, in some cases, in order to make the description clearer, the widths, thicknesses, shapes, etc., of the respective parts are illustrated schematically in the drawings, rather than as an accurate representation of what is implemented. However, such schematic illustration is merely exemplary, and in no way restricts the interpretation of the invention. In addition, in the specification and drawings, structural elements which function in the same or a similar manner to those described in connection with preceding drawings are denoted by like reference numbers, detailed description thereof being omitted unless necessary.

In the drawings, in order to facilitate understanding, an X-axis, a Y-axis and a Z-axis orthogonal to each other are shown depending on the need. A direction parallel to the X-axis is referred to as a first direction X. A direction parallel to the Y-axis is referred to as a second direction Y. A direction parallel to the Z-axis is referred to as a third direction Z. When various elements are viewed parallel to the third direction Z, the appearance is defined as a plan view. When terms indicating the positional relationships of two or more structural elements, such as "on", "above" "between" and "face", are used, the target structural elements may be directly in contact with each other or may be spaced apart from each other as a gap or another structural element is interposed between them. The positive direction of the Z-axis is referred to as "on" or "above".

The display device of the present embodiment is an organic electroluminescent display device comprising an organic light emitting diode (OLED) as a display element, and could be mounted on a television, a personal computer, a vehicle-mounted device, a tablet, a smartphone, a mobile phone, etc.

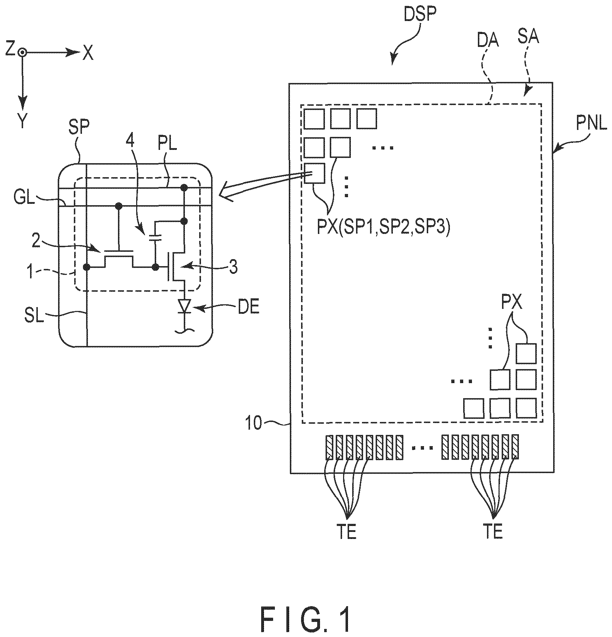

FIG. 1 is a plan view showing a configuration example of a display device DSP.

The display device DSP comprises a display panel PNL having a display area DA which displays an image and a surrounding area SA located on an external side relative to the display area DA on an insulating substrate 10. The substrate 10 may be either a glass substrate or a resinous substrate having flexibility.

In the embodiment, the substrate 10 is rectangular in plan view. It should be noted that the shape of the substrate 10 in plan view is not limited to a rectangle and may be another shape such as a square, a circle or an oval.

The display area DA comprises a plurality of pixels PX arrayed in matrix in a first direction X and a second direction Y. Each pixel PX includes a plurality of subpixels SP. For example, each pixel PX includes subpixel SP1 which exhibits a first color, subpixel SP2 which exhibits a second color and subpixel SP3 which exhibits a third color. The first color, the second color and the third color are different colors. Each pixel PX may include a subpixel SP which exhibits another color such as white in addition to subpixels SP1, SP2 and SP3 or instead of one of subpixels SP1, SP2 and SP3. It should be noted that the combination of subpixels is not limited to three elements. The combination may consist of two elements or may consist of four or more elements by adding subpixel SP4 etc., to subpixels SP1 to SP3.

Each subpixel SP comprises a pixel circuit 1 and a display element DE driven by the pixel circuit 1. The pixel circuit 1 comprises a pixel switch 2, a drive transistor 3 and a capacitor 4. Each of the pixel switch 2 and the drive transistor 3 is, for example, a switching element consisting of a thin-film transistor.

The gate electrode of the pixel switch 2 is connected to a scanning line GL. One of the source electrode and drain electrode of the pixel switch 2 is connected to a signal line SL. The other one is connected to the gate electrode of the drive transistor 3 and the capacitor 4. In the drive transistor 3, one of the source electrode and the drain electrode is connected to a power line PL and the capacitor 4, and the other one is connected to the anode of the display element DE.

It should be noted that the configuration of the pixel circuit 1 is not limited to the example shown in the figure. For example, the pixel circuit 1 may comprise more thin-film transistors and capacitors.

The display element DE is an organic light emitting diode (OLED) as a light emitting element, and may be called an organic EL element.

The surrounding area SA comprises a plurality of terminals TE which are unidirectionally arranged. In the example shown in the figure, the terminals TE are arranged in the first direction X. Each of the terminals TE extends in the second direction Y. However, the configuration is not limited to this example. For example, some of the terminals TE may extend in an oblique direction. For example, these terminals TE are electrically connected to a flexible printed circuit and an IC chip.

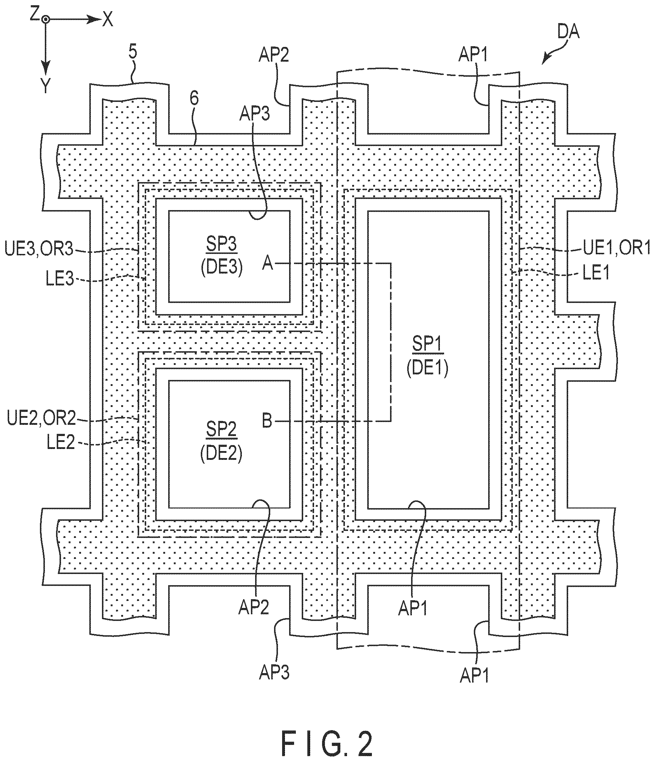

FIG. 2 is a diagram showing an example of the layout of subpixels SP1, SP2 and SP3.

In the example shown in the figure, subpixels SP2 and SP3 are arranged in the second direction Y. Subpixels SP1 and SP2 are arranged in the first direction X, and subpixels SP1 and SP3 are arranged in the first direction X.

When subpixels SP1, SP2 and SP3 are provided in line with this layout, a column in which subpixels SP2 and SP3 are alternately provided in the second direction Y and a column in which a plurality of subpixels SP1 are provided in the second direction Y are formed in the display area DA. These columns are alternately arranged in the first direction X.

It should be noted that the layout of subpixels SP1, SP2 and SP3 is not limited to the example of FIG. 2. As another example, subpixels SP1, SP2 and SP3 in each pixel PX may be arranged in order in the first direction X.

An insulating layer 5 and a partition 6 are provided in the display area DA. The insulating layer 5 has apertures AP1, AP2 and AP3 in subpixels SP1, SP2 and SP3, respectively. The insulating layer 5 having these apertures AP1, AP2 and AP3 may be called a rib.

The partition 6 overlaps the insulating layer 5 in plan view. The partition 6 is formed into a grating shape surrounding the apertures AP1, AP2 and AP3. In other words, the partition 6 has apertures in subpixels SP1, SP2 and SP3 in a manner similar to that of the insulating layer 5. The partition 6 is conductive and is electrically connected to, of the terminals TE shown in FIG. 1, terminals TE having a common potential.

Subpixels SP1, SP2 and SP3 comprise display elements DE1, DE2 and DE3, respectively, as the display elements DE.

The display element DE1 of subpixel SP1 comprises a lower electrode LE1, an upper electrode UE1 and an organic layer OR1 overlapping the aperture AP1. The lower electrode LE1, the organic layer OR1 and the upper electrode UE1 are surrounded by the partition 6 in plan view. The peripheral portion of each of the lower electrode LE1, the organic layer OR1 and the upper electrode UE1 overlaps the insulating layer 5 in plan view.

The display element DE2 of subpixel SP2 comprises a lower electrode LE2, an upper electrode UE2 and an organic layer OR2 overlapping the aperture AP2. The lower electrode LE2, the organic layer OR2 and the upper electrode UE2 are surrounded by the partition 6 in plan view. The peripheral portion of each of the lower electrode LE2, the organic layer OR2 and the upper electrode UE2 overlaps the insulating layer 5 in plan view.

The display element DE3 of subpixel SP3 comprises a lower electrode LE3, an upper electrode UE3 and an organic layer OR3 overlapping the aperture AP3. The lower electrode LE3, the organic layer OR3 and the upper electrode UE3 are surrounded by the partition 6 in plan view. The peripheral portion of each of the lower electrode LE3, the organic layer OR3 and the upper electrode UE3 overlaps the insulating layer 5 in plan view.

In the example shown in the figure, the outer shapes of the lower electrodes LE1, LE2 and LE3 are shown by broken lines, and the outer shapes of the organic layers OR1, OR2 and OR3 and the upper electrodes UE1, UE2 and UE3 are shown by alternate long and short dash lines. It should be noted that the outer shape of each of the lower electrodes, organic layers and upper electrodes shown in the figure does not necessarily reflect the accurate shape.

The lower electrodes LE1, LE2 and LE3 correspond to, for example, the anodes of the display elements. The upper electrodes UE1, UE2 and UE3 correspond to the cathodes of the display elements or a common electrode and are in contact with the partition 6.

In the example shown in the figure, the area of the aperture AP1, the area of the aperture AP2 and the area of the aperture AP3 are different from each other. The area of the aperture AP1 is greater than that of the aperture AP2, and the area of the aperture AP2 is greater than that of the aperture AP3. In other words, the area of the lower electrode LE1 exposed from the aperture AP1 is greater than that of the lower electrode LE2 exposed from the aperture AP2. The area of the lower electrode LE2 exposed from the aperture AP2 is greater than that of the lower electrode LE3 exposed from the aperture AP3.

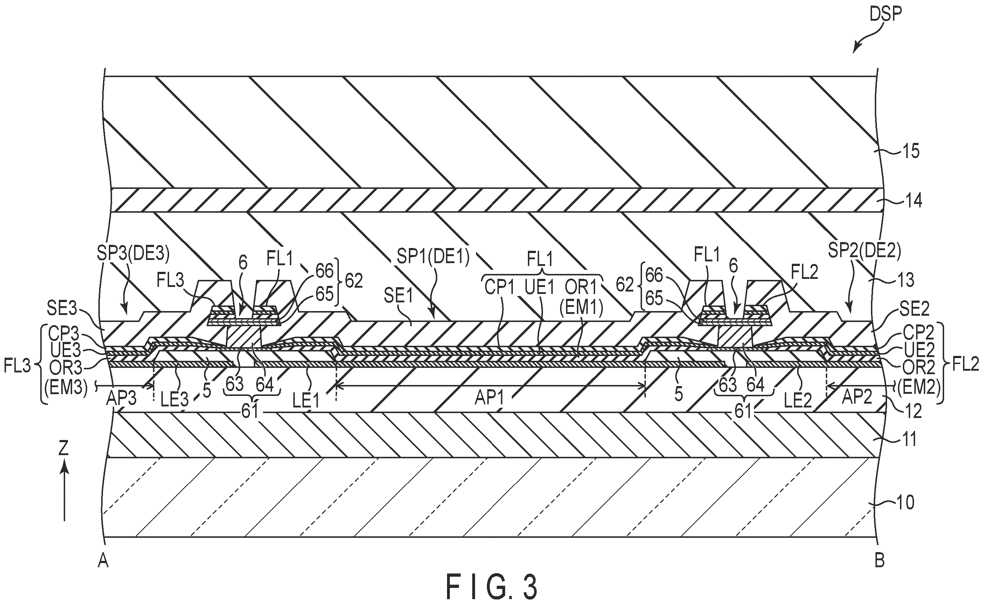

FIG. 3 is a schematic cross-sectional view of the display device DSP along the A-B line of FIG. 2.

A circuit layer 11 is provided on the substrate 10. The circuit layer 11 includes various circuits such as the pixel circuit 1 shown in FIG. 1 and various lines such as the scanning line GL, the signal line SL and the power line PL. The circuit layer 11 is covered with an insulating layer 12. The insulating layer 12 is an organic insulating layer which planarizes the irregularities formed by the circuit layer 11.

The lower electrodes LE1, LE2 and LE3 are provided on the insulating layer 12 and are spaced apart from each other. The insulating layer 5 is an inorganic insulating layer and is provided on the insulating layer 12 and the lower electrodes LE1, LE2 and LE3. The aperture AP1 of the insulating layer 5 overlaps the lower electrode LE1. The aperture AP2 overlaps the lower electrode LE2. The aperture AP3 overlaps the lower electrode LE3. The peripheral portions of the lower electrodes LE1, LE2 and LE3 are covered with the insulating layer 5. The lower electrodes LE1, LE2 and LE3 are connected to the pixel circuits 1 of subpixels SP1, SP2 and SP3, respectively, through contact holes provided in the insulating layer 12. The contact holes of the insulating layer 12 are omitted in FIG. 3.

The partition 6 includes a conductive lower portion 61 provided on the insulating layer 5 and an upper portion 62 provided on the lower portion 61. The upper portion 62 has a width greater than that of the lower portion 61. The both end portions of the upper portion 62 protrude relative to the side surfaces of the lower portion 61. This shape of the partition 6 is called an overhang shape.

In the example shown in the figure, the lower portion 61 has a first conductive layer 63 provided on the insulating layer 5 and a second conductive layer 64 provided on the first conductive layer 63. For example, the first conductive layer 63 is formed so as to be thinner than the second conductive layer 64. In the example shown in the figure, the both end portions of the first conductive layer 63 protrude from the side surfaces of the second conductive layer 64.

The upper portion 62 has a first thin film 65 provided on the second conductive layer 64 and a second thin film 66 provided on the first thin film 65. The both end portions of the first thin film 65 and the second thin film 66 protrude from the side surfaces of the second conductive layer 64.

The organic layer OR1 is in contact with the lower electrode LE1 through the aperture AP1 and covers the lower electrode LE1 exposed from the aperture AP1. The peripheral portion of the organic layer OR1 is located on the insulating layer 5. The upper electrode UE1 covers the organic layer OR1 and is in contact with the lower portion 61.

The organic layer OR2 is in contact with the lower electrode LE2 through the aperture AP2 and covers the lower electrode LE2 exposed from the aperture AP2. The peripheral portion of the organic layer OR2 is located on the insulating layer 5. The upper electrode UE2 covers the organic layer OR2 and is in contact with the lower portion 61.

The organic layer OR3 is in contact with the lower electrode LE3 through the aperture AP3 and covers the lower electrode LE3 exposed from the aperture AP3. The peripheral portion of the organic layer OR3 is located on the insulating layer 5. The upper electrode UE3 covers the organic layer OR3 and is in contact with the lower portion 61.

In the example shown in the figure, subpixel SP1 has a cap layer CP1 and a sealing layer SE1. Subpixel SP2 has a cap layer CP2 and a sealing layer SE2. Subpixel SP3 has a cap layer CP3 and a sealing layer SE3. The cap layers CP1, CP2 and CP3 function as optical adjustment layers which improve the extraction efficiency of the light emitted from the organic layers OR1, OR2 and OR3, respectively. It should be noted that at least one of the cap layers CP1, CP2 and CP3 may be omitted.

The cap layer CP1 is provided on the upper electrode UE1.

The cap layer CP2 is provided on the upper electrode UE2.

The cap layer CP3 is provided on the upper electrode UE3.

The sealing layer SE1 is provided on the cap layer CP1, is in contact with the partition 6 and continuously covers the members of subpixel SP1.

The sealing layer SE2 is provided on the cap layer CP2, is in contact with the partition 6 and continuously covers the members of subpixel SP2.

The sealing layer SE3 is provided on the cap layer CP3, is in contact with the partition 6 and continuously covers the members of subpixel SP3.

In the example shown in the figure, each of the organic layer OR1, the upper electrode UE1 and the cap layer CP1 is partly located on the partition 6 around subpixel SP1. These portions are spaced apart from, of the organic layer OR1, the upper electrode UE1 and the cap layer CP1, the portions located in the aperture AP1 (the portions constituting the display element DE1).

Similarly, each of the organic layer OR2, the upper electrode UE2 and the cap layer CP2 is partly located on the partition 6 around subpixel SP2. These portions are spaced apart from, of the organic layer OR2, the upper electrode UE2 and the cap layer CP2, the portions located in the aperture AP2 (the portions constituting the display element DE2).

Similarly, each of the organic layer OR3, the upper electrode UE3 and the cap layer CP3 is partly located on the partition 6 around subpixel SP3. These portions are spaced apart from, of the organic layer OR3, the upper electrode UE3 and the cap layer CP3, the portions located in the aperture AP3 (the portions constituting the display element DE3).

In the following explanation, a multilayer body including the organic layer OR1, the upper electrode UE1 and the cap layer CP1 is called a stacked film FL1. A multilayer body including the organic layer OR2, the upper electrode UE2 and the cap layer CP2 is called a stacked film FL2. A multilayer body including the organic layer OR3, the upper electrode UE3 and the cap layer CP3 is called a stacked film FL3.

The end portions of the sealing layers SE1, SE2 and SE3 and the end portions of the stacked films FL1, FL2 and FL3 are located on the partition 6. In the example shown in the figure, the stacked film FL1 and sealing layer SE1 located on the partition 6 between subpixels SP1 and SP2 are spaced apart from the stacked film FL2 and sealing layer SE2 located on this partition 6. The stacked film FL1 and sealing layer SE1 located on the partition 6 between subpixels SP1 and SP3 are spaced apart from the stacked film FL3 and sealing layer SE3 located on this partition 6.

The partition 6 and the sealing layers SE1, SE2 and SE3 are covered with a resin layer 13. The resin layer 13 is covered with a sealing layer 14. The sealing layer 14 is covered with a resin layer 15.

Each of the insulating layer 5, the sealing layers SE1, SE2 and SE3 and the sealing layer 14 is formed of, for example, an inorganic insulating material such as silicon nitride (SiNx), silicon oxide (SiOx), silicon oxynitride (SiON) or aluminum oxide (Al₂O₃).

The lower portion 61 of the partition 6 is formed of a conductive material and is electrically connected to the upper electrodes UE1, UE2 and UE3. The first conductive layer 63 is formed of, for example, a titanium-based material such as titanium or a titanium compound. The second conductive layer 64 is formed of a material which is different from the first conductive layer 63 and the upper portion 62, and is formed of, for example, an aluminum-based material such as aluminum or an aluminum compound.

The upper portion 62 of the partition 6 is formed of, for example, a conductive material. However, the upper portion 62 may be formed of an insulating material. The first thin film 65 is formed of, for example, a titanium-based material such as titanium or a titanium compound. The second thin film 66 is formed of, for example, an oxide conductive material such as indium tin oxide (ITO).

Each of the lower electrodes LE1, LE2 and LE3 is a multilayer body including a transparent layer formed of an oxide conductive material such as indium tin oxide (ITO) and a reflective layer formed of a metal material such as silver. For example, each of the lower electrodes LE1, LE2 and LE3 is a multilayer body including a reflective layer between a pair of transparent layers. The lower transparent layer functions as an adhesive layer which adheres tightly to the insulating layer 12.

The organic layer OR1 includes a light emitting layer EM1. The organic layer OR2 includes a light emitting layer EM2. The organic layer OR3 includes a light emitting layer EM3. The light emitting layer EM1, the light emitting layer EM2 and the light emitting layer EM3 are formed of materials which are different from each other. For example, the light emitting layer EM1 is formed of a material which emits light in a blue wavelength range. The light emitting layer EM2 is formed of a material which emits light in a green wavelength range. The light emitting layer EM3 is formed of a material which emits light in a red wavelength range.

Each of the organic layers OR1, OR2 and OR3 includes a plurality of functional layers such as a hole injection layer, a hole transport layer, an electron blocking layer, a hole blocking layer, an electron transport layer, an electron injection layer and a charge generation layer.

Each of the upper electrodes UE1, UE2 and UE3 is formed of, for example, a metal material such as an alloy of magnesium and silver (MgAg).

Each of the cap layers CP1, CP2 and CP3 is a multilayer body consisting of a plurality of thin films. All of the thin films are transparent and have refractive indices which are different from each other.

The circuit layer 11, insulating layer 12, insulating layer 5, resin layer 13, resin layer 15 and sealing layer 14 shown in the figure are provided over the display area DA and the surrounding area SA.

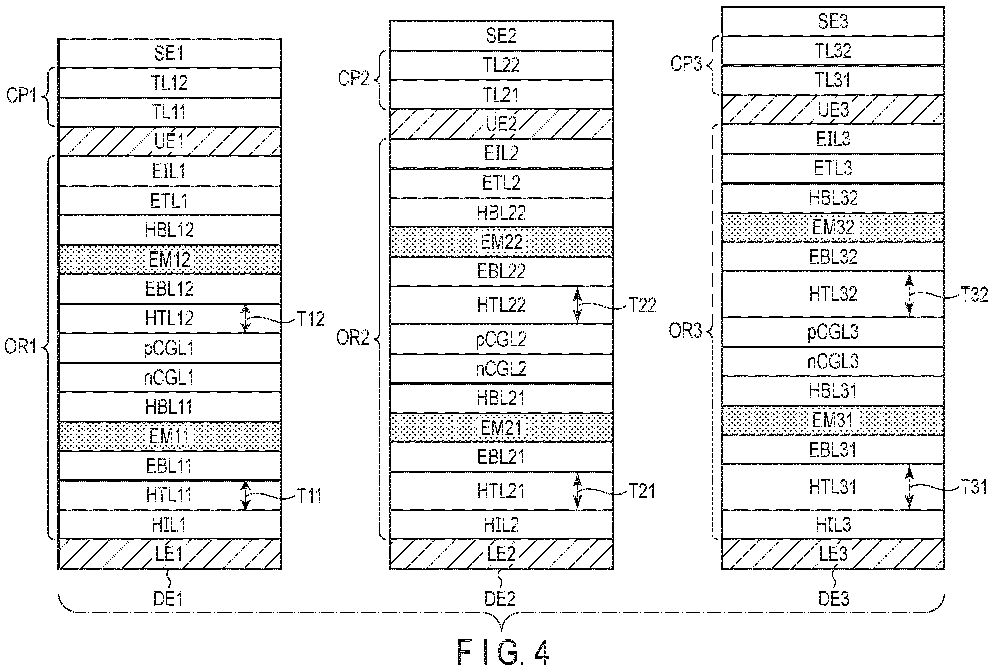

FIG. 4 is a diagram showing configuration examples of the display elements DE1 to DE3.

Here, in the examples, this specification explains a case where each lower electrode corresponds to an anode and each upper electrode corresponds to a cathode.

The display element DE1 includes the organic layer OR1 between the lower electrode LE1 and the upper electrode UE1.

In the organic layer OR1, a hole injection layer HIL1, a hole transport layer HTL11, an electron blocking layer EBL11, a light emitting layer (first light emitting layer) EM11, a hole blocking layer HBL11, an n-type charge generation layer nCGL1, a p-type charge generation layer pCGL1, a hole transport layer HTL12, an electron blocking layer EBL12, a light emitting layer (second light emitting layer) EM12, a hole blocking layer HBL12, an electron transport layer ETL1 and an electron injection layer EIL1 are stacked in this order.

The hole transport layers HTL11 and HTL12 can be formed of the same material.

The electron blocking layers EBL11 and EBL12 can be formed of the same material.

The light emitting layers EM11 and EM12 can be formed of the same material.

The hole blocking layers HBL11 and HBL12 can be formed of the same material.

The n-type charge generation layer nCGL1 is a functional layer which supplies electrons to the light emitting layer EM11 and is a metal doped layer formed of lithium, ytterbium, etc.

The p-type charge generation layer pCGL1 is a functional layer which supplies positive holes to the light emitting layer EM12 and is formed of a HAT-based material.

The cap layer CP1 including a first transparent layer TL11 and a second transparent layer TL12 is provided on the upper electrode UE1. The sealing layer SE1 is provided on the second transparent layer TL12.

The display element DE2 includes the organic layer OR2 between the lower electrode LE2 and the upper electrode UE2.

In the organic layer OR2, a hole injection layer HIL2, a hole transport layer HTL21, an electron blocking layer EBL21, a light emitting layer EM21, a hole blocking layer HBL21, an n-type charge generation layer nCGL2, a p-type charge generation layer pCGL2, a hole transport layer HTL22, an electron blocking layer EBL22, a light emitting layer EM22, a hole blocking layer HBL22, an electron transport layer ETL2 and an electron injection layer EIL2 are stacked in this order.

The hole transport layers HTL21 and HTL22 can be formed of the same material. For example, thickness T21 of the hole transport layer HTL21 is different from thickness T11 of the hole transport layer HTL11 in some cases. Thickness T22 of the hole transport layer HTL22 is different from thickness T12 of the hole transport layer HTL12 in some cases.

The electron blocking layers EBL21 and EBL22 can be formed of the same material.

The light emitting layers EM21 and EM22 can be formed of the same material. The material of the light emitting layers EM21 and EM22 is different from that of the light emitting layers EM11 and EM12.

The hole blocking layers HBL21 and HBL22 can be formed of the same material.

The n-type charge generation layer nCGL2 is a functional layer which supplies electrons to the light emitting layer EM21.

The p-type charge generation layer pCGL2 is a functional layer which supplies positive holes to the light emitting layer EM22.

The cap layer CP2 including a first transparent layer TL21 and a second transparent layer TL22 is provided on the upper electrode UE2. The sealing layer SE2 is provided on the second transparent layer TL22.

The display element DE3 includes the organic layer OR3 between the lower electrode LE3 and the upper electrode UE3.

In the organic layer OR3, a hole injection layer HIL3, a hole transport layer HTL31, an electron blocking layer EBL31, a light emitting layer EM31, a hole blocking layer HBL31, an n-type charge generation layer nCGL3, a p-type charge generation layer pCGL3, a hole transport layer HTL32, an electron blocking layer EBL32, a light emitting layer EM32, a hole blocking layer HBL32, an electron transport layer ETL3 and an electron injection layer EIL3 are stacked in this order.

The hole transport layers HTL31 and HTL32 can be formed of the same material. For example, thickness T31 of the hole transport layer HTL31 is different from thickness T11 and thickness T21 in some cases. Thickness T32 of the hole transport layer HTL32 is different from thickness T12 and thickness T22 in some cases.

The electron blocking layers EBL31 and EBL32 can be formed of the same material.

The light emitting layers EM31 and EM32 can be formed of the same material. The material of the light emitting layers EM31 and EM32 is different from that of the light emitting layers EM11 and EM12 and is different from that of the light emitting layers EM21 and EM22.

The hole blocking layers HBL31 and HBL32 can be formed of the same material.

The n-type charge generation layer nCGL3 is a functional layer which supplies electrons to the light emitting layer EM31.

The p-type charge generation layer pCGL3 is a functional layer which supplies positive holes to the light emitting layer EM32.

The cap layer CP3 including a first transparent layer TL31 and a second transparent layer TL32 is provided on the upper electrode UE3. The sealing layer SE3 is provided on the second transparent layer TL32.

In this specification, the configuration of the display elements DE1 to DE3 shown in FIG. 4 is called a tandem configuration. In this tandem configuration, the current efficiency is improved compared to a single configuration in which an organic layer OR has a single light emitting layer. Thus, in case of the same current density, the luminance can be increased in a tandem configuration compared to a single configuration. In addition, since the light emission efficiency is improved, the life can be extended in a tandem configuration compared to a single configuration when the luminance is the same in the configurations.

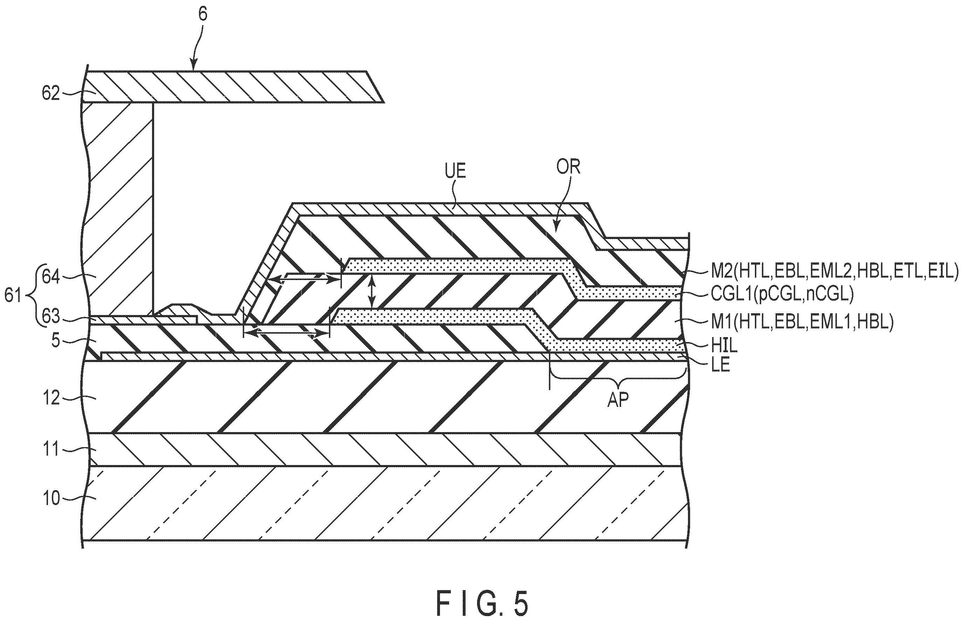

FIG. 5 is a schematic cross-sectional view showing a configuration example of an organic layer OR.

Here, this specification explains a structure common to the display elements DE1 to DE3 shown in FIG. 4. The lower electrode LE shown in the figure corresponds to the lower electrodes LE1, LE2 and LE3. The aperture AP corresponds to the apertures AP1, AP2 and AP3. The organic layer OR corresponds to the organic layers OR1, OR2 and OR3. The upper electrode UE corresponds to the upper electrodes UE1, UE2 and UE3.

The organic layer OR has a hole injection layer HIL, a first intermediate layer M1, a first charge generation layer CGL1 and a second intermediate layer M2. The first intermediate layer M1 has a hole transport layer HTL, an electron blocking layer EBL, a first light emitting layer EML1 and a hole blocking layer HBL. The first charge generation layer CGL1 has an n-type charge generation layer nCGL and a p-type charge generation layer pCGL. The second intermediate layer M2 has a hole transport layer HTL, an electron blocking layer EBL, a second light emitting layer EML2, a hole blocking layer HBL, an electron transport layer ETL and an electron injection layer EIL.

The hole injection layer HIL is in contact with the lower electrode LE in the aperture AP, extends to the upper side of the insulating layer 5 and is spaced apart from the partition 6. The end portion of the hole injection layer HIL is located on the insulating layer 5 and is located immediately under the upper portion 62.

The first intermediate layer M1 is provided on the hole injection HIL. In the example shown in the figure, the first intermediate layer M1 covers the hole injection layer HIL. Thus, the first intermediate layer M1 covers the end portion of the hole injection layer HIL and is in contact with the insulating layer 5 between the hole injection layer HIL and the partition 6. The end portion of the first intermediate layer M1 is located on the insulating layer 5 and is located immediately under the upper portion 62. In the example shown in the figure, the first intermediate layer M1 is spaced apart from the partition 6.

The first charge generation layer CGL1 is provided on the first intermediate layer M1. The first charge generation layer CGL1 is spaced apart from the partition 6 and is also spaced apart from the hole injection layer HIL. The end portion of the first charge generation layer CGL1 is located on the first intermediate layer M1 and is located immediately under the upper portion 62.

The second intermediate layer M2 is provided on the first charge generation layer CGL1. In the example shown in the figure, the second intermediate layer M2 covers the first intermediate layer M1 and the first charge generation layer CGL1. Thus, the second intermediate layer M2 covers the end portion of the first charge generation layer CGL1 and is in contact with the first intermediate layer M1. Further, the second intermediate layer M2 covers the end portion of the first intermediate layer M1 and is in contact with the insulating layer 5 between the hole injection layer HIL and the partition 6. The end portion of the second intermediate layer M2 is located on the insulating layer 5 and is located immediately under the upper portion 62. In the example shown in the figure, the second intermediate layer M2 is spaced apart from the partition 6.

The upper electrode UE is provided on the second intermediate layer M2. The upper electrode UE is spaced apart from the hole injection layer HIL and the first charge generation layer CGL1. In the example shown in the figure, the upper electrode UE covers the second intermediate layer M2. Thus, the upper electrode UE covers the end portion of the second intermediate layer M2 and is in contact with the lower portion 61 of the partition 6. In the example shown in the figure, the second intermediate layer M2 is spaced apart from the partition 6. The upper electrode UE is in contact with the insulating layer 5 between the second intermediate layer M2 and the first conductive layer 63.

Thus, the hole injection layer HIL is covered with the first intermediate layer M1 and is spaced apart from the upper electrode UE. The first charge generation layer CGL1 is covered with the second intermediate layer M2 and is spaced apart from the upper electrode UE. Further, the hole injection layer HIL and the first charge generation layer CGL1 are spaced apart from each other. This configuration prevents carrier leakage via the hole injection layer HIL and the first charge generation layer CGL1. In this manner, the disturbance in the balance of carrier injection inside each display element is prevented, thereby realizing the desired display performance.

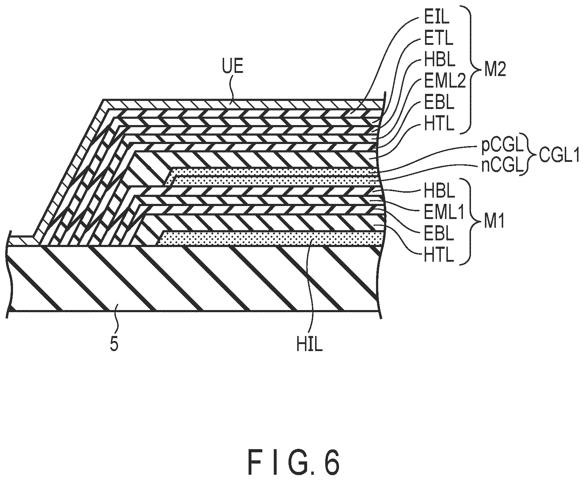

FIG. 6 is a cross-sectional view of the organic layer OR shown in FIG. 5.

In the first intermediate layer M1, the hole transport layer HTL is provided on the hole injection layer HIL and covers the entire hole injection layer HIL including the end portion of the hole injection layer HIL. The electron blocking layer EBL is provided on the hole transport layer HTL and covers the entire hole transport layer HTL including the end portion of the hole transport layer HTL. The first light emitting layer EML1 is provided on the electron blocking layer EBL and covers the entire electron blocking layer EBL including the end portion of the electron blocking layer EBL. The hole blocking layer HBL is provided on the first light emitting layer EML1 and covers the entire first light emitting layer EML1 including the end portion of the first light emitting layer EML1.

In the first charge generation layer CGL1, the n-type charge generation layer nCGL is provided on the hole blocking layer HBL. The p-type charge generation layer pCGL is provided on the n-type charge generation layer nCGL. In the example shown in the figure, the p-type charge generation layer pCGL covers the entire n-type charge generation layer nCGL including the end portion of the n-type charge generation layer nCGL.

In the second intermediate layer M2, the hole transport layer HTL is provided on the p-type charge generation layer pCGL and covers the entire p-type charge generation layer pCGL including the end portion of the p-type charge generation layer pCGL. The electron blocking layer EBL is provided on the hole transport layer HTL and covers the entire hole transport layer HTL including the end portion of the hole transport layer HTL. The second light emitting layer EML2 is provided on the electron blocking layer EBL and covers the entire electron blocking layer EBL including the end portion of the electron blocking layer EBL. The hole blocking layer HBL is provided on the second light emitting layer EML2 and covers the entire second light emitting layer EML2 including the end portion of the second light emitting layer EML2. The electron transport layer ETL is provided on the hole blocking layer HBL and covers the entire hole blocking layer HBL including the end portion of the hole blocking layer HBL. The electron injection layer EIL is provided on the electron transport layer ETL and covers the entire electron transport layer ETL including the end portion of the electron transport layer ETL.

The upper electrode UE covers the electron injection layer EIL. In the example shown in the figure, the first intermediate layer M1 and the second intermediate layer M2 are interposed between the upper electrode UE and the hole injection layer HIL. The second intermediate layer M2 is interposed between the upper electrode UE and the first charge generation layer CGL1. The first intermediate layer M1 is interposed between the hole injection layer HIL and the first charge generation layer CGL1. By this configuration, mutual electric insulation can be assured with respect to the hole injection layer HIL, the first charge generation layer CGL1 and the upper electrode UE.

Now, another configuration example is explained.

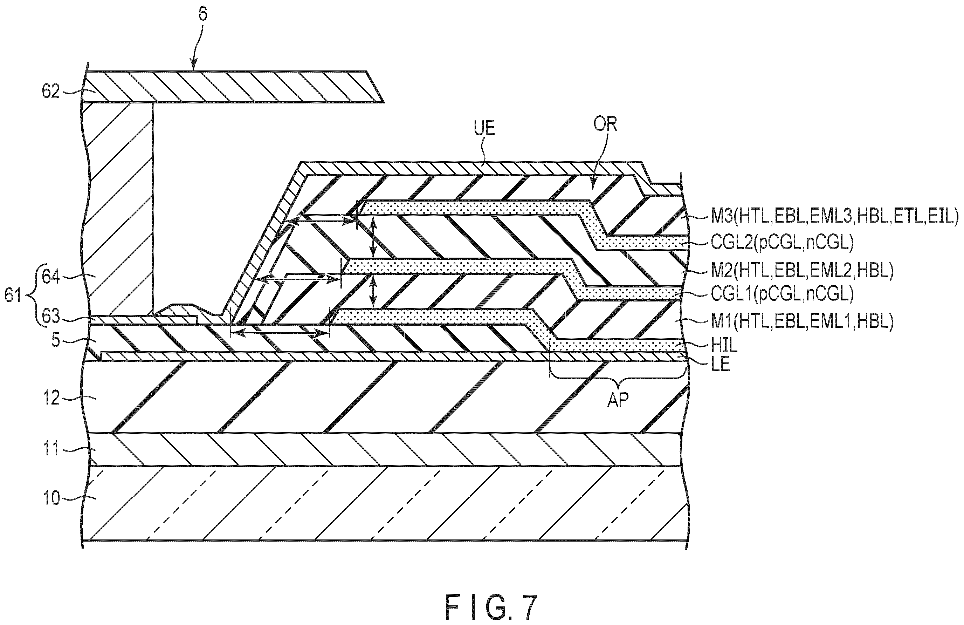

FIG. 7 is a schematic cross-sectional view showing another configuration example of an organic layer OR.

The configuration example shown in FIG. 7 is different from that shown in FIG. 5 in respect that the organic layer OR has a second charge generation layer CGL2 and a third intermediate layer M3 between a second intermediate layer M2 and an upper electrode UE. It should be noted that the configurations of a first intermediate layer M1 and a first charge generation layer CGL1 are the same as the example shown in FIG. 5.

The second intermediate layer M2 has a hole transport layer HTL, an electron blocking layer EBL, a second light emitting layer EML2 and a hole blocking layer HBL. The second charge generation layer CGL2 has an n-type charge generation layer nCGL and a p-type charge generation layer pCGL. The third intermediate layer M3 has a hole transport layer HTL, an electron blocking layer EBL, a third light emitting layer EML3, a hole blocking layer HBL, an electron transport layer ETL and an electron injection layer EIL.

A hole injection layer HIL is in contact with a lower electrode LE in an aperture AP, extends to the upper side of the insulating layer 5 and is spaced apart from the partition 6.

The first intermediate layer M1 is provided on the hole injection HIL. In the example shown in the figure, the first intermediate layer M1 covers the hole injection layer HIL and is spaced apart from the partition 6.

The first charge generation layer CGL1 is provided on the first intermediate layer M1 and is spaced apart from the partition 6 and the hole injection layer HIL.

The second intermediate layer M2 is provided on the first charge generation layer CGL1. In the example shown in the figure, the second intermediate layer M2 covers the first intermediate layer M1 and the first charge generation layer CGL1 and is spaced apart from the partition 6.

The second charge generation layer CGL2 is provided on the second intermediate layer M2. Further, the second charge generation layer CGL2 is spaced apart from all of the partition 6, the hole injection layer HIL and the first charge generation layer CGL1. The end portion of the second charge generation layer CGL2 is located on the second intermediate layer M2 and is located immediately under the upper portion 62.

The third intermediate layer M3 is provided on the second charge generation layer CGL2. In the example shown in the figure, the third intermediate layer M3 covers the second intermediate layer M2 and the second charge generation layer CGL2. Thus, the third intermediate layer M3 covers the end portion of the second charge generation layer CGL2 and is in contact with the second intermediate layer M2. Further, the third intermediate layer M3 covers the end portion of the second intermediate layer M2 and is in contact with the insulating layer 5 between the hole injection layer HIL and the partition 6. The end portion of the third intermediate layer M3 is located on the insulating layer 5 and is located immediately under the upper portion 62. In the example shown in the figure, the third intermediate layer M3 is spaced apart from the partition 6.

The upper electrode UE is provided on the third intermediate layer M3. The upper electrode UE is spaced apart from all of the hole injection layer HIL, the first charge generation layer CGL1 and the second charge generation layer CGL2. In the example shown in the figure, the upper electrode UE covers the third intermediate layer M3. Thus, the upper electrode UE covers the end portion of the third intermediate layer M3 and is in contact with the lower portion 61 of the partition 6. In the example shown in the figure, the third intermediate layer M3 is spaced apart from the partition 6. The upper electrode UE is in contact with the insulating layer 5 between the third intermediate layer M3 and the first conductive layer 63.

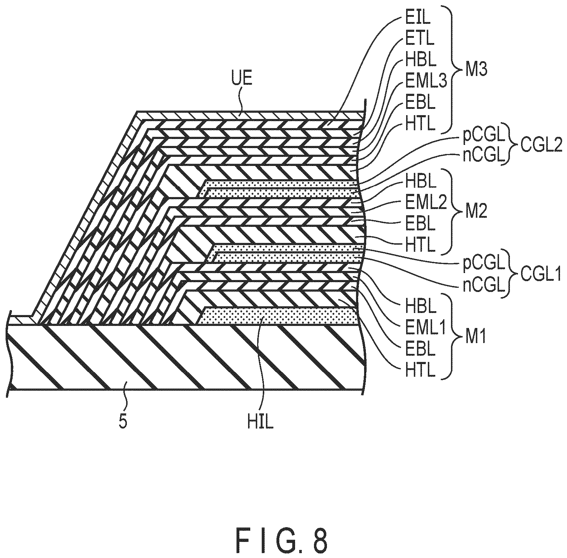

FIG. 8 is a cross-sectional view of the organic layer OR shown in FIG. 7.

In the first intermediate layer M1, the hole transport layer HTL is provided on the hole injection layer HIL and covers the entire hole injection layer HIL including the end portion of the hole injection layer HIL. The electron blocking layer EBL is provided on the hole transport layer HTL and covers the entire hole transport layer HTL including the end portion of the hole transport layer HTL. The first light emitting layer EM1 is provided on the electron blocking layer EBL and covers the entire electron blocking layer EBL including the end portion of the electron blocking layer EBL. The hole blocking layer HBL is provided on the first light emitting layer EML1 and covers the entire first light emitting layer EML1 including the end portion of the first light emitting layer EML1.

In the first charge generation layer CGL1, the n-type charge generation layer nCGL is provided on the hole blocking layer HBL. The p-type charge generation layer pCGL is provided on the n-type charge generation layer nCGL. In the example shown in the figure, the p-type charge generation layer pCGL covers the entire n-type charge generation layer nCGL including the end portion of the n-type charge generation layer nCGL.

In the second intermediate layer M2, the hole transport layer HTL is provided on the p-type charge generation layer pCGL and covers the entire p-type charge generation layer pCGL including the end portion of the p-type charge generation layer pCGL. The electron blocking layer EBL is provided on the hole transport layer HTL and covers the entire hole transport layer HTL including the end portion of the hole transport layer HTL. The second light emitting layer EML2 is provided on the electron blocking layer EBL and covers the entire electron blocking layer EBL including the end portion of the electron blocking layer EBL. The hole blocking layer HBL is provided on the second light emitting layer EML2 and covers the entire second light emitting layer EML2 including the end portion of the second light emitting layer EML2.

In the second charge generation layer CGL2, the n-type charge generation layer nCGL is provided on the hole blocking layer HBL. The p-type charge generation layer pCGL is provided on the n-type charge generation layer nCGL. In the example shown in the figure, the p-type charge generation layer pCGL covers the entire n-type charge generation layer nCGL including the end portion of the n-type charge generation layer nCGL.

In the third intermediate layer M3, the hole transport layer HTL is provided on the p-type charge generation layer pCGL and covers the entire p-type charge generation layer pCGL including the end portion of the p-type charge generation layer pCGL. The electron blocking layer EBL is provided on the hole transport layer HTL and covers the entire hole transport layer HTL including the end portion of the hole transport layer HTL. The third light emitting layer EML3 is provided on the electron blocking layer EBL and covers the entire electron blocking layer EBL including the end portion of the electron blocking layer EBL. The hole blocking layer HBL is provided on the third light emitting layer EML3 and covers the entire third light emitting layer EML3 including the end portion of the third light emitting layer EML3.

The electron transport layer ETL is provided on the hole blocking layer HBL and covers the entire hole blocking layer HBL including the end portion of the hole blocking layer HBL. The electron injection layer EIL is provided on the electron transport layer ETL and covers the entire electron transport layer ETL including the end portion of the electron transport layer ETL.

The upper electrode UE covers the electron injection layer EIL. In the example shown in the figure, the first intermediate layer M1, the second intermediate layer M2 and the third intermediate layer M3 are interposed between the upper electrode UE and the hole injection layer HIL. The second intermediate layer M2 and the third intermediate layer M3 are interposed between the upper electrode UE and the first charge generation layer CGL1. The third intermediate layer M3 is interposed between the upper electrode UE and the second charge generation layer CGL2. The first intermediate layer M1 is interposed between the hole injection layer HIL and the first charge generation layer CGL1. The second intermediate layer M2 is interposed between the first charge generation layer CGL1 and the second charge generation layer CGL2.

By this configuration, mutual electric insulation can be assured with respect to the hole injection layer HIL, the first charge generation layer CGL1, the second charge generation layer CGL2 and the upper electrode UE. Thus, effects similar to those of the above configuration example are obtained.

In the example shown in FIG. 7 and FIG. 8, this specification explains a tandem configuration in which the organic layer OR has three light emitting layers. However, the organic layer OR may have four or more light emitting layers.

Now, this specification explains the manufacturing method of the display device DSP. Regarding each figure for explaining the manufacturing method, the illustration of the lower side than the insulating layer 12 is omitted.

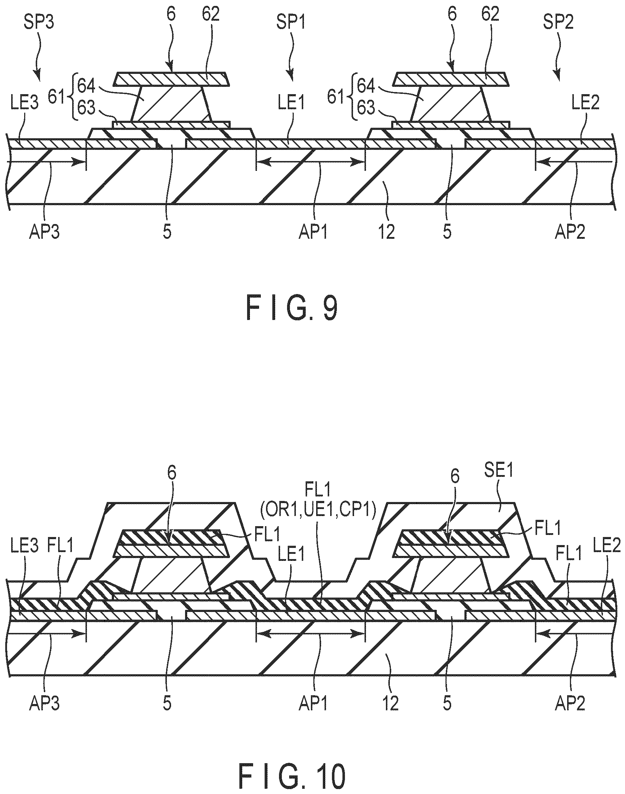

First, the circuit layer 11 and the insulating layer 12 are formed on the substrate 10 over the display area DA and the surrounding area SA. Subsequently, as shown in FIG. 9, the lower electrode LE1 of subpixel SP1, the lower electrode LE2 of subpixel SP2 and the lower electrode LE3 of subpixel SP3 are formed on the insulating layer 12.

Subsequently, the insulating layer 5 which covers the peripheral portions of the lower electrodes LE1, LE2 and LE3 is formed. The insulating layer 5 is formed of an inorganic insulating material such as silicon oxide, silicon nitride or silicon oxynitride.

Subsequently, the partition 6 which has the lower portion 61 located on the insulating layer 5 and the upper portion 62 located on the lower portion 61 is formed. The first conductive layer 63 of the lower portion 61 and the upper portion 62 protrude from the side surfaces of the second conductive layer 64 of the lower portion 61. The first conductive layer 63 is formed of a conductive material such as a titanium-based material, and the second conductive layer 64 is formed of a conductive material such as an aluminum-based material.

It should be noted that the process of forming the apertures AP1, AP2 and AP3 in the insulating layer 5 may be performed either before the partition 6 is formed or after the partition 6 is formed.

Subsequently, the display element DE1 is formed.

First, as shown in FIG. 10, the stacked film FL1 including the organic layer OR1, the upper electrode UE1 and the cap layer CP1 is formed. The process of forming the stacked film FL1 includes the process of forming the organic layer OR1 which is in contact with the lower electrode LE1 in the aperture AP1, the process of forming the upper electrode UE1 which covers the organic layer OR1 and is in contact with the lower portion 61 of the partition 6, and the process of forming the cap layer CP1 located on the upper electrode UE1. The process of forming the organic layer OR1 includes the process of forming each of a hole injection layer, a hole transport layer, an electron blocking layer, a plurality of light emitting layers, a hole blocking layer, an electron transport layer, an electron injection layer, an n-type charge generation layer and a p-type charge generation layer. Each of the organic layer OR1, the upper electrode UE1 and the cap layer CP1 is formed by vapor deposition using the partition 6 as a mask. The stacked film FL1 is divided into a plurality of portions by the partition 6 having an overhang shape. These organic layer OR1, upper electrode UE1 and cap layer CP1 are continuously formed while maintaining a vacuum environment.

Subsequently, the sealing layer SE1 is formed on the stacked film FL1 by depositing an inorganic insulating material. The sealing layer SE1 is formed by chemical vapor deposition (CVD). The sealing layer SE1 continuously covers the portions into which the stacked film FL1 is divided, and the partition 6.

Here, the process of forming each layer of an organic layer OR is more specifically explained.

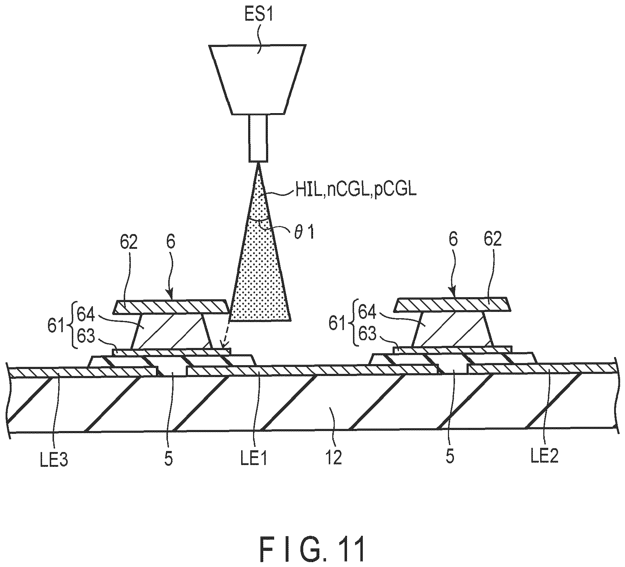

FIG. 11 is a diagram for explaining the formation process of a hole injection layer HIL, an n-type charge generation layer nCGL and a p-type charge generation layer pCGL.

A first evaporation source ES1 is configured to emit a material at a first evaporation angle Θ1. Here, the evaporation angle is the spread angle of the material emitted from the evaporation source. The evaporation angle can be controlled by the shapes of a nozzle from which the material is emitted, a shield which surrounds the nozzle, etc.

The materials for forming the hole injection layer HIL, the n-type charge generation layer nCGL and the p-type charge generation layer pCGL are emitted from the first evaporation source ES1 set to the first evaporation angle Θ1 as shown in the figure. The first evaporation angle Θ1 is set so as to be an angle which is relatively small.

Therefore, for example, when the material for forming the hole injection layer HIL is emitted from the first evaporation source ES1, the emitted material is blocked by the upper portion 62 near the partition 6 and reaches a position distant from the partition 6 immediately under the upper portion 62. Thus, the area of the hole injection layer HIL formed inside the area surrounded by the partition 6 is relatively small. In addition, the areas of the n-type charge generation layer nCGL and the p-type charge generation layer pCGL on the inner side of the partition 6 are relatively small.

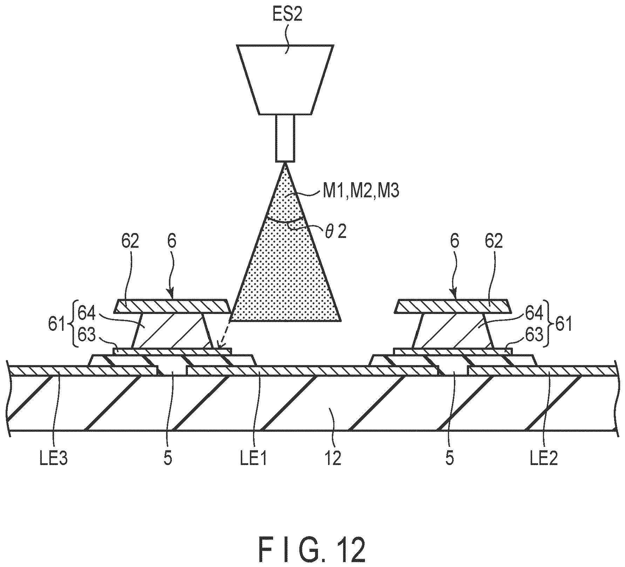

FIG. 12 is a diagram for explaining the formation process of the first intermediate layer M1, the second intermediate layer M2 and the third intermediate layer M3.

A second evaporation source ES2 is configured to emit a material at a second evaporation angle θ2. The second evaporation angle θ2 is greater than the first evaporation angle Θ1 shown in FIG. 11 (θ1 < θ2). The materials for forming the first intermediate layer M1, the second intermediate layer M2 and the third intermediate layer M3 are emitted from the second evaporation source ES2 set to the second evaporation angle θ2 as shown in the figure.

Therefore, for example, when the material for forming the hole transport layer of the first intermediate layer M1 is emitted from the second evaporation source ES2, the emitted material reaches a position close to the partition 6 immediately under the upper portion 62. Thus, the area of the hole transport layer HTL formed inside the area surrounded by the partition 6 is relatively large. On the inner side of the partition 6, the areas of the first intermediate layer M1, the second intermediate layer M2 and the third intermediate layer M3 including the hole transport layer HTL are greater than those of the hole injection layer HIL, the n-type charge generation layer nCGL and the p-type charge generation layer pCGL. In this manner, the hole injection layer HIL, the n-type charge generation layer nCGL and the p-type charge generation layer pCGL are covered with at least one of the first intermediate layer M1, the second intermediate layer M2 and the third intermediate layer M3.

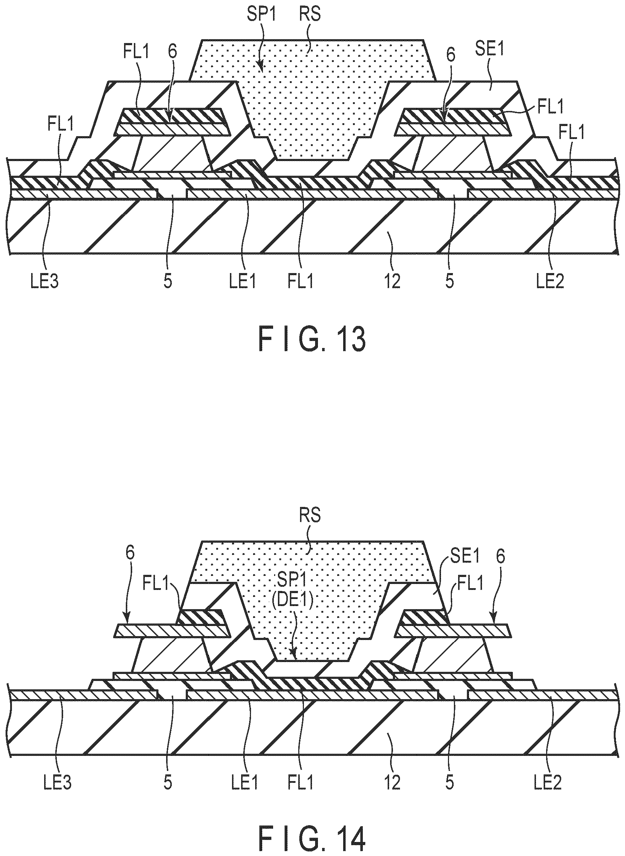

Subsequently, as shown in FIG. 13, a resist RS patterned into a predetermined shape is formed on the sealing layer SE1. The resist RS overlaps subpixel SP1 and part of the partition 6 around subpixel SP1.

Subsequently, as shown in FIG. 14, the sealing layer SE1 and the stacked film FL1 exposed from the resist RS are removed in series by performing etching using the resist RS as a mask. In this etching, the sealing layer SE1 exposed from the resist RS is removed. Subsequently, the cap layer CP1 exposed from the sealing layer SE1 is removed. Further, the upper electrode UE1 exposed from the cap layer CP1 is removed. Subsequently, the organic layer OR1 exposed from the upper electrode UE1 is removed. In this manner, the lower electrode LE2 of subpixel SP2 and the lower electrode LE3 of subpixel SP3 are exposed.

Subsequently, the resist RS is removed. By this process, the display element DE1 is formed in subpixel SP1.

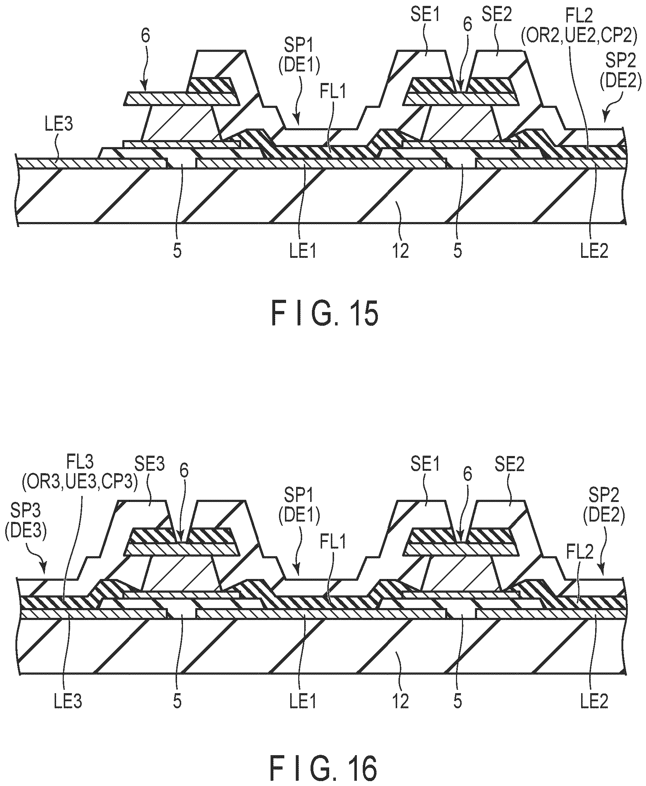

Subsequently, as shown in FIG. 15, the display element DE2 is formed. The procedure of forming the display element DE2 is similar to that of forming the display element DE1. Specifically, the stacked film FL2 is formed by forming the organic layer OR2 including the light emitting layer EM2, the upper electrode UE2 and the cap layer CP2 in order on the lower electrode LE2. Subsequently, the sealing layer SE2 is formed on the stacked film FL2. Subsequently, a resist is formed on the sealing layer SE2. The sealing layer SE2, the cap layer CP2, the upper electrode UE2 and the organic layer OR2 are patterned by etching using the resist as a mask. After this patterning, the resist is removed. By this process, the display element DE2 is formed in subpixel SP2, and the lower electrode LE3 of subpixel SP3 is exposed.

Subsequently, as shown in FIG. 16, the display element DE3 is formed. The procedure of forming the display element DE3 is similar to that of forming the display element DE1. Specifically, the stacked film FL3 is formed by forming the organic layer OR3 including the light emitting layer EM3, the upper electrode UE3 and the cap layer CP3 in order on the lower electrode LE3. Subsequently, the sealing layer SE3 is formed on the stacked film FL3. Subsequently, a resist is formed on the sealing layer SE3. The sealing layer SE3, the cap layer CP3, the upper electrode UE3 and the organic layer OR3 are patterned by etching using the resist as a mask. After this patterning, the resist is removed. By this process, the display element DE3 is formed in subpixel SP3.

Subsequently, the resin layer 13, sealing layer 14 and resin layer 15 shown in FIG. 3 are formed in order. By this process, the display device DSP is completed.

In the manufacturing process described above, this specification assumes a case where the display element DE1 is formed firstly, and the display element DE2 is formed secondly, and the display element DE3 is formed lastly. However, the formation order of the display elements DE1, DE2 and DE3 is not limited to this example.

As explained above, the embodiment can provide a display device in which the degradation of the display performance can be prevented and a manufacturing method thereof.

All of the display devices and manufacturing methods thereof that can be implemented by a person of ordinary skill in the art through arbitrary design changes to the display device and manufacturing method thereof described above as the embodiment of the present invention come within the scope of the present invention as long as they are in keeping with the spirit of the present invention.

Various modification examples which may be conceived by a person of ordinary skill in the art in the scope of the idea of the present invention will also fall within the scope of the invention. For example, even if a person of ordinary skill in the art arbitrarily modifies the above embodiment by adding or deleting a structural element or changing the design of a structural element, or by adding or omitting a step or changing the condition of a step, all of the modifications fall within the scope of the present invention as long as they are in keeping with the spirit of the invention.

Further, other effects which may be obtained from the above embodiment and are self-explanatory from the descriptions of the specification or can be arbitrarily conceived by a person of ordinary skill in the art are considered as the effects of the present invention as a matter of course.

## Claims

1. A display device **characterized by** comprising:
a substrate (10);
a lower electrode (LE) provided above the substrate (10);
an inorganic insulating layer (5) which covers a peripheral portion of the lower electrode (LE);
a partition (6) which has a conductive lower portion (61) provided on the inorganic insulating layer (5) and an upper portion (62) provided on the lower portion (61) and protruding from a side surface of the lower portion (61);
an organic layer (OR) provided on the lower electrode (LE); and
an upper electrode (UE) which is provided on the organic layer (OR) and is in contact with the lower portion (61), wherein
the organic layer (OR) has a hole injection layer (HIL) which is spaced apart from the partition (6) and is in contact with the lower electrode (LE), a first intermediate layer (M1) provided on the hole injection layer (HIL) and including a first light emitting layer (EML1), a first charge generation layer (CGL1) spaced apart from the partition (6) and provided on the first intermediate layer (M1), and a second intermediate layer (M2) provided on the first charge generation layer (CGL1) and including a second light emitting layer (EML2), and
the hole injection layer (HIL) and the first charge generation layer (CGL1) are spaced apart from each other and are further spaced apart from the upper electrode (UE).

2. The display device of claim 1, **characterized in that**
the first intermediate layer (M1) and the second intermediate layer (M2) are in contact with each other.

3. The display device of claim 2, **characterized in that**
an end portion of the first intermediate layer (M1) is covered with the second intermediate layer (M2) .

4. The display device of claim 1, **characterized in that**
the first intermediate layer (M1) covers an end portion of the hole injection layer (HIL) and is in contact with the inorganic insulating layer (5) between the hole injection layer (HIL) and the partition (6).

5. The display device of claim 4, **characterized in that**
the first intermediate layer (M1) has a hole transport layer (HTL) provided on the hole injection layer (HIL), an electron blocking layer (EBL) provided on the hole transport layer (HTL), the first light emitting layer (EML1) provided on the electron blocking layer (EBL), and a hole blocking layer (HBL) provided on the first light emitting layer (EML1), and
the hole transport layer (HTL) covers the end portion of the hole injection layer (HIL).

6. The display device of claim 5, **characterized in that**
the first charge generation layer (CGL1) has an n-type charge generation layer (nCGL) provided on the hole blocking layer (HBL), and a p-type charge generation layer (pCGL) provided on the n-type charge generation layer (nCGL).

7. The display device of claim 1, **characterized in that**
the second intermediate layer (M2) covers an end portion of the first charge generation layer (CGL1) and is in contact with the inorganic insulating layer (5) between the hole injection layer (HIL) and the partition (6).

8. The display device of claim 7, **characterized in that**
the second intermediate layer (M2) has a hole transport layer (HTL) provided on the first charge generation layer (CGL1), an electron blocking layer (EBL) provided on the hole transport layer (HTL), the second light emitting layer (EML2) provided on the electron blocking layer (EBL), a hole blocking layer (HBL) provided on the second light emitting layer (EML2), an electron transport layer (ETL) provided on the hole blocking layer (HBL), and an electron injection layer (EIL) provided on the electron transport layer (ETL), and
the hole transport layer (HTL) covers the end portion of the first charge generation layer (CGL1).

9. The display device of claim 8, **characterized in that**
the upper electrode (UE) covers the electron injection layer (EIL).

10. The display device of claim 1, **characterized in that**
the organic layer further has a second charge generation layer (CGL2) spaced apart from the partition (6) and provided on the second intermediate layer (M2), and a third intermediate layer (M3) provided on the second charge generation layer (CGL2) and including a third light emitting layer (EML3), and
the hole injection layer (HIL), the first charge generation layer (CGL1) and the second charge generation layer (CGL2) are spaced apart from each other and are further spaced apart from the upper electrode (UE).

11. The display device of claim 10, **characterized in that**
the third intermediate layer (M3) covers an end portion of the second charge generation layer (CGL2) and is in contact with the inorganic insulating layer (5) between the hole injection layer (HIL) and the partition (6).

12. The display device of claim 11, **characterized in that**
the third intermediate layer (M3) has a hole transport layer (HTL) provided on the second charge generation layer (CGL2), an electron blocking layer (EBL) provided on the hole transport layer (HTL), the third light emitting layer (EML3) provided on the electron blocking layer (EBL), a hole blocking layer (HBL) provided on the third light emitting layer (EML3), an electron transport layer (ETL) provided on the hole blocking layer (HBL), and an electron injection layer (EIL) provided on the electron transport layer (ETL), and
the hole transport layer (HTL) covers the end portion of the second charge generation layer (CGL2).

13. The display device of claim 12, **characterized in that**
the upper electrode (UE) covers the electron injection layer (EIL).

14. The display device of claim 1, **characterized in that**
an end portion of the hole injection layer (HIL) and an end portion of the first charge generation layer (CGL1) are located immediately under the upper portion (62) .

15. A display device **characterized by** comprising:
a substrate (10);
a lower electrode (LE) provided above the substrate (10);
an inorganic insulating layer (5) which covers a peripheral portion of the lower electrode (LE);
a partition (6) which has a conductive lower portion (61) provided on the inorganic insulating layer (5) and an upper portion (62) provided on the lower portion (61) and protruding from a side surface of the lower portion (61);
an organic layer (OR) provided on the lower electrode (LE); and
an upper electrode (UE) which is provided on the organic layer (OR) and is in contact with the lower portion (61), wherein
the organic layer (OR) has a hole injection layer (HIL) which is spaced apart from the partition (6) and is in contact with the lower electrode (LE), a first intermediate layer (M1) covering the hole injection layer (HIL) and including a first light emitting layer (EML1), a first charge generation layer (CGL1) spaced apart from the partition (6) and provided on the first intermediate layer (M1), and a second intermediate layer (M2) covering the first intermediate layer (M1) and the first charge generation layer (CGL1) and including a second light emitting layer (EML2).

16. The display device of claim 15, **characterized in that**
the first intermediate layer (M1) has a hole transport layer (HTL) which covers the hole injection layer (HIL), an electron blocking layer (EBL) which covers the hole transport layer (HTL), the first light emitting layer (EML1) which covers the electron blocking layer (EBL), and a hole blocking layer (HBL) which covers the first light emitting layer (EML1), and
the first charge generation layer (CGL1) is provided on the hole blocking layer (HBL).

17. The display device of claim 15, **characterized in that**
the second intermediate layer (M2) has a hole transport layer (HTL) which covers the first charge generation layer (CGL1), an electron blocking layer (EBL) which covers the hole transport layer (HTL), the second light emitting layer (EML2) which covers the electron blocking layer (EBL), a hole blocking layer (HBL) which covers the second light emitting layer (EML2), an electron transport layer (ETL) which covers the hole blocking layer (HBL), and an electron injection layer (EIL) which covers the electron transport layer (ETL), and
the upper electrode (UE) covers the electron injection layer (EIL).

18. A manufacturing method of a display device, **characterized by** comprising:
forming a lower electrode (LE) above a substrate (10) ;
forming an inorganic insulating layer (5) which covers a peripheral portion of the lower electrode (LE) ;
forming a partition (6) which has a lower portion (61) located on the inorganic insulating layer (5) and formed of a conductive material, and an upper portion (62) located on the lower portion (61) and protruding from a side surface of the lower portion (61); and
forming a stacked film including an organic layer (OR) and an upper electrode (UE) on the lower electrode (LE) by performing vapor deposition using the partition (6) as a mask, wherein
the organic layer (OR) has a hole injection layer (HIL), a first intermediate layer (M1) including a first light emitting layer (EML1), a first charge generation layer (CGL1), and a second intermediate layer (M2) including a second light emitting layer (EML2),
each of the hole injection layer (HIL) and the first charge generation layer (CGL1) is formed of a material emitted from a first evaporation source (ES1) at a first evaporation angle (θ1), using the partition (6) as a mask,
each of the first intermediate layer (M1) and the second intermediate layer (M2) is formed of a material emitted from a second evaporation source (ES2) at a second evaporation angle (θ2), using the partition (6) as a mask, and
the second evaporation angle (θ2) is greater than the first evaporation angle (θ1).

19. The manufacturing method of claim 18, **characterized by** further comprising, after forming the stacked film,
forming a sealing layer (SE) which covers the stacked film and the partition (6) by using an inorganic insulating material.

20. The manufacturing method of claim 19, **characterized by** further comprising, after forming the sealing layer,
forming a patterned resist (RS) on the sealing layer (SE), and
removing the sealing layer (SE) and the stacked film exposed from the resist (RS) in series by performing etching using the resist (RS) as a mask.
